# EUROPÄISCHE PATENTSCHRIFT

(11) **EP 0 791 226 B1**
(45) Veröffentlichungstag und Bekanntmachung des Hinweises auf die Patenterteilung: **26.01.2000**
(21) Anmeldenummer: 95937758.1
(22) Anmeldetag: 09.11.1995
(51) Int. Cl.: H01J 37/32, C23C 14/32

(54) **VORRICHTUNG ZUM BESCHICHTEN VON SUBSTRATEN MIT EINEM MATERIALDAMPF IM UNTERDRUCK ODER VAKUUM**
DEVICE FOR COATING SUBSTRATES USING A VAPOUR PHASE MATERIAL IN A REDUCED PRESSURE OR VACUUM ENVIRONMENT
DISPOSITIF POUR LE RECOUVREMENT DE SUBSTRATS AU MOYEN D'UN MATERIAU EN PHASE VAPEUR, SOUS PRESSION REDUITE OU SOUS VIDE

(30) Priorität: 12.11.1994 DE 4440521
(43) Veröffentlichungstag der Anmeldung: 27.08.1997
(73) Patentinhaber: Rowo Coating Gesellschaft Für Beschichtung MbH, 79336 Herbolzheim (DE); APVV Angewandte Plasma-, Vakuum- und Verfahrenstechnik GmbH, 45307 Essen (DE)
(72) Erfinder: HASSE, Brunhilde, D-77955 Ettenheim (DE); SIEFERT, Wolfgang, D-77955 Ettenheim (DE)
(74) Vertreter: Goy, Wolfgang, Dipl.-Phys.
(86) Internationale Anmeldenummer: DE9501577
(87) Internationale Veröffentlichungsnummer: WO9615544

(56) Entgegenhaltungen:
- WO-A-93/14240
- WO-A-94/09176
- WO-A-95/16798
- DE-C- 4 425 221
- GB-A- 1 447 754

## Beschreibung

Die Erfindung betrifft eine Vorrichtung zum Beschichten von Substraten mit einem Materialdampf im Unterdruck oder Vakuum, mit einer Materialdampfquelle sowie mit einer aus einer kalten Anode und aus einer Kathode bestehenden lonisationseinrichtung zum lonisieren des Materialdampfes in einer ein Plasma erzeugenden, durch den Materialdampf gestützten Bogenentladung zwischen Anode und Kathode, wobei die Materialdampfquelle und die lonisationseinrichtung mit ihrer Anode und Kathode elektrisch voneinander getrennt sind.

Erfindungsgebiet ist somit das Beschichten von Substraten, beispielsweise Folien, Platten oder Formteile. Es gibt dabei verschiedene Methoden, derartige Substrate zu beschichten. Zum einen gibt es die Möglichkeit, neutrale Teilchen thermisch zu verdampfen, welche sich dann auf dem zu beschichtenden Material niederschlagen. Als weitere Möglichkeit gibt es das Aufstäuben. Schließlich gibt es als Verfahren das Aufbringen von ionisierten Teilchen auf die zu beschichtende Oberfläche, wobei zu diesem Zweck ein elektrisches Feld Zwischen einer Anode und einer Kathode erzeugt wird, in dem die Ionisation der Teilchen in einem Plasma stattfindet. Es ist dabei allgemein bekannt, daß bei der Erzeugung dünner Schichten im Vakuum eine lonisierung des Materialdampfes zu verbesserten Schichteigenschaften führt. Insbesondere die Haftung und die Kompaktheit der Schichten können dadurch deutlich verbessert werden. Außerdem ist die Möglichkeit einer reaktiven Abscheidung gegeben. Die Ionisation der Materialdämpfe kann durch elektrische Entladungen erreicht werden, wobei zwischen Glimm- und Lichtbogenentladungen unterschieden wird. Von diesem letzteren Verfahren geht die Erfindung aus.

Aus der DE-OS 42 00 429 ist eine Beschichtungsvorrichtung bekannt, bei der thermisch erzeugte Materialdämpfe durch einen anodisch bestimmten Vakuumlichtbogen ionisiert werden. Die Grundidee besteht dabei darin, daß die Verdampfungseinrichtung sowohl der Erzeugung des Materialdampfes als auch als Anode dient, indem der materialdampferzeugende Tiegel als Anode geschaltet wird. Die bekannte Vorrichtung hat zwar den Vorteil, daß zur Aufrechterhaltung des Lichtbogens kein Prozeßgas benötigt wird, doch besitzt die bekannte Beschichtungsvorrichtung auch etliche Nachteile. So ist beispielsweise nachteilig, daß der elektrische Schaltkreis des thermischen Verdampfers mit dem elektrischen Schaltkreis des Lichtbogens gekoppelt ist und sich somit gegenseitig störend beeinflussen können. So werden beispielsweise in einem stromdurchflossenen Tiegel so hohe Magnetfelder erzeugt, daß der Stromfluß zwischen Tiegel (Anode) und Kathode so stark erschwert ist, daß die Ionisation und damit die Anodenaktivität nicht mehr oder nur gering stattfindet. Der Bogen brennt dadurch sehr instabil. Ein weiterer Nachteil ist die Parallelschaltung des ohmschen Widerstandes des Tiegels mit dem Plasmawiderstand über dem Tiegel. Liegt nämlich der Plasmawiderstand in der gleichen Größenordnung wie der Tiegelwiderstand, so wird der effektive ohmsche Tiegelwiderstand reduziert. Somit sind Ionisation und Verdampfungsrate eng miteinander gekoppelt, was die Optimierung der Beschichtung über lonisierung und Verdampfungsrate stark einschränkt. Ein weiterer Nachteil schließlich ist die räumliche Fixierung der Ionisation auf den Tiegelbereich, da der Tiegel gleichzeitig als Anode fungiert.

Aus der DE-OS 42 17 450 ist ein lonenplatierverfahren sowie eine zugehörige lonenplatiervorrichtung mit einer Materialdampfquelle in einem haubenartigen lonisationsraum und einer elektrisch getrennt versorgten Elektronstrahlkanone, deren Strahl durch eine seitliche Öffnung in der Haube eintritt und dabei das in einem Tiegel befindliche Material verdampft, bekannt. Diese Vorrichtung dient zur lonenbedampfung von Metallbändern.

In der DD-PS 145 283 wird ein Verfahren zur Erzeugung von verschleißfesten und korrosionsbeständigen Schichten bei metallischen Werkstücken durch lonenbehandlung im Vakuum beschrieben. Die Vorrichtung weist einen Materialverdampfer auf sowie in senkrechter Anordnung hierzu eine lonisierungsquelle. Weiterhin ist eine Versorgungseinheit für Reaktivgase vorgesehen. Die Stromquellen für den Verdampfer und die lonisierungsquelle sind elektrisch voneinander getrennt. Die Vorrichtung dient zur reaktiven lonenbedampfung mit verschleißfesten Hartstoffschichten.

In der CH-PS 683 776 ist eine Vorrichtung zur kontinuierlichen lonenbedampfung von Verpackungsfolienbändem offenbart. Die Vorrichtung besteht dabei aus einem Materialverdampfer mit dazugehöriger Elektronenkanone sowie aus einer lonisierungseinrichtung unter Verwendung einer Hohlkathoden-Niederspannungselektronenstrahlkanone, deren Strahl senkrecht zum Dampfstrahl geführt wird. Auch hier erfolgt die Stromversorgung aus elektrisch getrennten Quellen.

Die US-PS 4 336 277 offenbart eine Vorrichtung mit einer lonisierungseinrichtung aus Anode und Glühkathode zur Erzeugung eines ionisierenden Elektronenstrahls sowie einer Materialdampfquelle. Dabei besteht eine elektrische Trennung mit getrennten Stromversorgungen für den Verdampfer und die lonisierungseinrichtung. Die Vorrichtung wird bei reaktiver lonenbedampfung verwendet.

In der US-PS 4 692 230 ist eine Vorrichtung zum Aufstäuben von Schichtstapeln offenbart. Auch hier ist ebenfalls eine elektrische Trennung der Materialdampfquelle in Form von Magnetronzerstäubungskathoden und der lonisierungseinrichtung aus Glühkathode und Anode vorgesehen.

In der US-PS 3 482 133 ist eine Quelle zum Erzeugen von Ionen oder Elektronen offenbart, wobei mittels des Ionen- oder Elektronenstroms ein keramisches Material verdampft werden soll. Die Ladungsträgerquelle weist eine Kathode in Form einer dünnen Metallplatte sowie einen davor befindliche Anode in Form eines Metallnetzes auf.

In der WO 94/09176 ist eine Einrichtung zum plasmagestützten Elektronenstrahl-Hochratebedampfen der eingangs angegebenen Art offenbart. Das Grundprinzip besteht darin, daß in einem Verdampfer das Verdampfungsmaterial mittels eines Elektronenstrahls verdampft wird. Zwischen diesem Verdampfer und dem zu beschichtenden Substrat befindet sich ein Plasma zusammen mit einem Magnetfeld. Das Plasma wird durch eine Bogenentladung zwischen einer Hohlkathode und einer wassergekühlten Anode erzeugt. - Der besondere Nachteil dieser Quelle als Plasmaaktivierungsquelle ist insbesondere die hohe Betriebstemperatur der heißen Hohlkathode. Die hohe Betriebstemperatur der Hohlkathode führt zu einer hohen Störanfälligkeit der Quelle, insbesondere auch dann, wenn Reaktivgase eingesetzt werden. Der mechanische Aufbau der Quelle muß sehr sorgfältig erfolgen, damit die hohen Temperaturen realisiert werden können. Das zur Aufrechterhaltung der Hohlkathodenbogenentladung notwendige Arbeitsgas wird mit in die Schichten eingebaut und führt zu Störungen im Schichtaufbau.

Davon ausgehend liegt der Erfindung die **Aufgabe** zugrunde, eine Vorrichtung zum Beschichten von Substraten mit einem Materialdampf im Unterdruck oder Vakuum mit einer verbesserten Kathode zu schaffen.

Als technische **Lösung** wird mit der Erfindung vorgeschlagen, daß die Kathode eine kalte, selbstverzehrende Kathode ist, bei der die Elektronenemission zum Aufbau der Bogenentladung in mikroskopisch kleinen, extrem heißen Kathodenflecken an der Oberfläche der Kathode erfolgt.

Dadurch ist eine Vorrichtung zum Beschichten von Substraten mit einem Materialdampf im Unterdruck oder Vakuum unter Verwendung einer kalten Kathode geschaffen. Der besondere Vorteil der kalten Kathode besteht in ihrer niedrigen Betriebstemperatur, wodurch die Störanfälligkeit der Quelle auf ein Minimum reduziert ist. Diese niedrige Störanfälligkeit der Quelle ist auch dann gewährleistet, wenn Reaktivgase eingesetzt werden. Der mechanische Aufbau der Quelle kann darüber hinaus sehr einfach erfolgen. Schließlich besteht ein weiterer Vorteil in der Verwendung einer kalten Kathode darin, daß für die Aufrechterhaltung der Bogenentladung keine Arbeitsgas eingesetzt werden muß. Neben der kalten Kathode wird außerdem eine kalte Anode verwendet. Unter einer "kalten" Anode wird eine inaktive, nicht selbst verzehrende, nur stromführende Elektrode verstanden. Die "kalte" Anode weist dabei eine Temperatur unterhalb des Erweichungspunktes des Anodenmaterials auf, bei der während des Betriebs der Bogenentladung Schmelz- und/oder Verdampfungsprozesse nicht auftreten. Die "kalte" Anode kann daher im Hinblick auf diese Definition im herkömmlichen Sinne durchaus heiß sein. Letztendlich hängt die Kalttemperatur der Anode vom jeweiligen Anodenmaterial ab. Wichtig ist, daß keine Aufschmelz- und Verdampfungsprozesse an der Anode stattfinden. Allerdings liegt die Temperatur der "kalten" Anode vorzugsweise doch derart hoch, daß Kondensationsprozesse auf der Anodenoberfläche so gut wie möglich unterdrückt werden, um die elektrische Leitfähigkeit der Anode aufrechtzuerhalten. Diese Kondensationsprozesse spielen insbesondere bei Reaktivprozessen eine Rolle, bei denen der erzeugte Materialdampf mit einem zusätzlich zugeführten Reaktivgas oder Reaktivgasgemisch chemisch reagiert. Durch die schaltungstechnische Trennung der Materialdampfquelle von der lonisationseinrichtung mit der völligen elektrischen Entkopplung gibt es keinerlei gegenseitige störende Beeinflussung. Außerdem sind die Aufdampfrate und der lonisationsgrad voneinander entkoppelt und somit über einen weiten Bereich unabhängig voneinander variier- und optimierbar, wobei die Parameter individuell entsprechend den Bedürfnissen eingestellt werden können, da die beiden Parameter "lonisationsgrad" sowie "Verdampfungsrate" getrennt voneinander sind.

Vorteilhafte Weiterbildungen ergeben sich aus den Unteransprüchen 2 bis 14.

Eine Weiterbildung schlägt vor, daß die Anode und/oder die Kathode zur Erreichung ihres gewünschten kalten Zustandes kühlbar oder heizbar ist (sind). Indem die Temperatur der kalten Anode und/oder Kathode durch Kühlen oder Heizen beeinflußbar ist, kann die optimale Betriebstemperatur unter Beachtung vorstehender Kriterien eingestellt werden. Selbstverständlich kann auch eine nicht aktive Anode eingesetzt werden, welche nicht gekühlt oder geheizt wird, sofern sie das Kriterium der Inaktivität insbesondere im Hinblick auf die zuvorgenannten Kriterien erfüllt.

Eine weitere Weiterbildung schlägt vor, daß die Anode aus einem elektrisch leitenden, schwerschmelzenden sowie hochtemperaturfesten Material besteht. Es kann sich hier um Metalle oder Metallegierungen handeln (beispielsweise Wolfram oder Molybdän). Als Anodenmaterial ist aber auch Graphit oder eine Mischkeramik denkbar, wobei bei der letztgenannten Mischkeramik in dem Keramikmaterial ein elektrisch leitendes Material, insbesondere Metalle enthalten sind. Selbstverständlich sind weitere Materialien denkbar und nicht auf die genannten Materialien beschränkt.

Eine weitere Weiterbildung der erfindungsgemäßen Beschichtungsvorrichtung schlägt vor, daß im Bereich der Anode ein zusätzliches Magnetfeld angelegt ist. Das Anlegen eines zusätzlichen Magnetfeldes dient der Homogenisierung des anodischen Ansatzes und damit auch der Unterdrückung der Anodenaktivität. Magnetfelder treten nämlich dann auf, wenn der Verdampfungsprozeß durch hohe Ströme oder Stromdichten beispielsweise bei einer Widerstandsbeheizung bedingt ist. Durch das zusätzlich überlagerte Magnetfeld sollen diese Magnetfelder nahe der Anode kompensiert werden, die ansonsten zur Stromkonzentration nahe der Anode führen. Ziel der Magnetfeldüberlagerung ist somit eine homogene Verteilung.

Eine weitere bevorzugte Weiterbildung schlägt vor, daß die Spannungsversorgung für Anode und Kathode gepulst ist. Indem somit die Stromversorgung zwischen Anode und Kathode periodisch für eine kurze Zeitdauer ein- und ausgestellt wird, kann dadurch der Aufschmelzprozeß auf der Anode verhindert oder zumindest hinausgezögert werden, so daß dadurch die Anodenlebensdauer entsprechend verlängert wird. Die Bogenentladung bricht zwar während der Aus-Phase zusammen, doch ist die Frequenz sowie Dauer der Ein- sowie Aus-Phasen so zu wählen, daß dennoch eine gleichmäßige Substratbeschichtung mit dem Materialdampf möglich ist.

Eine weitere Weiterbildung schlägt vor, daß eine zusätzliche Einrichtung zur Erhöhung der Kathodenstabilität durch Homogenisierung des Kathodenabbrandes vorgesehen ist. Die Erhöhung der Kathodenstabilität ist dann gefordert, wenn das Kathodenmaterial ungleich dem Verdampfungsmaterial ist. Die Zusatzeinrichtung kann ein Magnetfeld (Permanentmagnet oder Elektromagnet), eine Abdeckung eines Teils der Kathodenoberfläche (bewirkt zudem geringeren Abbrand) und/oder eine geeignete Anordnung der Kathodenoberfläche sein, so daß diese nicht unmittelbar dem Materialdampf ausgesetzt ist.

Eine weitere Weiterbildung schlägt vor, daß eine zusätzliche Zündeinrichtung zur Zündung der Bogenentladung vorgesehen ist. Die Zündung kann dabei über eine sogenannte Gleitentladung erfolgen, über einen kleinen thermischen Verdampfer zwischen Kathode und einer Hilfsanode oder über einen Bimetallkontakt. Das Netzgerät kann eine Leerlaufspannung unter 100 Volt besitzen, wobei ein separater Zündpuls einige 100 Volt besitzt. Selbstverständlich ist es auch denkbar, ein Netzgerät mit einer Leerlaufspannung von einigen 100 Volt einzusetzen.

Eine weitere Weiterbildung schlägt vor, daß eine zusätzliche Einrichtung zur Beschleunigung der Ionen vorgesehen ist. Eine DC oder gepulste (unipolar oder bipolar) Spannungsversorgung kann dabei zwischen Anode und Substrat oder zwischen Anode und Tiegel oder zwischen Substrat und einer Hilfselektrode anliegen. Durch eine derartige Bias-Spannung wird die Beschichtung des Substrats verbessert.

Vorzugsweise ist in einer weiteren Weiterbildung der erfindungsgemäßen Beschichtungsvorrichtung die lonisationseinrichtung zwischen der Materialdampfquelle und dem zu beschichtenden Substrat angeordnet. Der Vorteil liegt darin, daß sich dadurch symmetrische Verhältnisse einstellen lassen, bei denen sich die Substratfläche vis a vis vom Plasma befindet, während die Materialdampfquelle auf der anderen Seite des Plasmas angeordnet ist und gleichmäßig die verdampften Teile an das Plasma abgeben kann.

Eine weitere bevorzugte Weiterbildung schlägt vor, daß der Abstand zwischen dem Ort der Ionisationseinrichtung und/oder dem Ort des zu beschichtenden Substrats und/oder dem Ort der Materialdampfquelle veränderbar ist. Durch die räumliche Trennung der Elektroden von der Materialdampfquelle ergibt sich die Möglichkeit, den Ort der Ionisation in Bezug auf den Abstand zum Substrat zu variieren, ein weiterer Parameter zur Optimierung. Von den drei Elementen, nämlich der lonisationseinrichtung, der Materialquelle sowie dem Substrat, können zwei beliebige Element-Paare in ihrer örtlichen Zuordnung zueinander variiert werden. Selbstverständlich ist es auch denkbar, alle drei Elemente ortsveränderlich anzuordnen.

Eine weitere Weiterbildung der erfindungsgemäßen Beschichtungsvorrichtung schlägt vor, daß als Materialdampfquelle ein Materialdampferzeuger mittels thermischem Verdampfen mit widerstands-, induktiv- oder elektronenstrahlbeheizten Tiegeln, mittels Sputtertechnik, anodischem oder kathodischem Lichtbogenverdampfen oder eine Materialdampfzuführung mit einem entsprechenden Gas oder Gasgemisch vorgesehen ist. Bei den Materialdampferzeugem der vorbeschriebenen Art handelt es sich um an sich bekannte Techniken. Als Materialdampfquelle ist aber auch das CVD (Chemical Vapor Deposition)-Verfahren anwendbar, indem anstelle des Dampferzeugers eine Zuführung für die entsprechenden Reaktivgaskomponenten vorgesehen ist. Somit wird der Materialdampf als Gas oder Gasgemisch aus Gaserzeugern oder Gasbehältern zur erfindungsgemäßen Beschichtungsvorrichtung geführt.

Eine weitere bevorzugte Weiterbildung der erfindungsgemäßen Beschichtungsvorrichtung schlägt vor, daß der lonisationszone über eine entsprechende Zuführung ein Reaktivgas oder Reaktivgasgemisch zuführbar ist. Dadurch ist eine Möglichkeit zur reaktiven Abscheidung gegeben, d. h. das erfindungsgemäße Beschichtungsverfahren kann auch zur reaktiven Abscheidung angewendet werden, indem durch eine geeignete Reaktivgaszuführung das Reaktivgas oder das Reaktivgasgemisch in die lonisationszone geführt wird. Insbesondere wird das Reaktivgas und das Reaktivgasgemisch in den Bereich der Bogenentladung zugeführt. Eine Weiterbildung hiervon schlägt vor, daß die Anode als Zuführung für das Reaktivgas oder Reaktivgasgemisch ausgebildet ist. Zu diesem Zweck kann als Zuführung für das Reaktivgas oder Reaktivgasgemisch die Anode in Rohrform mit Öffnungen ausgebildet sein. Die besonders vorteilhafte Weiterbildung der Erfindung besteht somit darin, die Anode beispielsweise in Rohrform als Zuführung für ein Reaktivgas auszubilden. Durch definierte Öffnungen entlang des Rohres kann das Reaktivgas direkt in die Entladung des Lichtbogens geführt werden, wo es gezielt aktiviert werden kann. Wird beispielsweise im Dampferzeuger Aluminium verdampft und über das Anodenrohr Sauerstoff zugeführt, so können Aluminiumoxidschichten bei hohen Abscheideraten erzeugt werden.

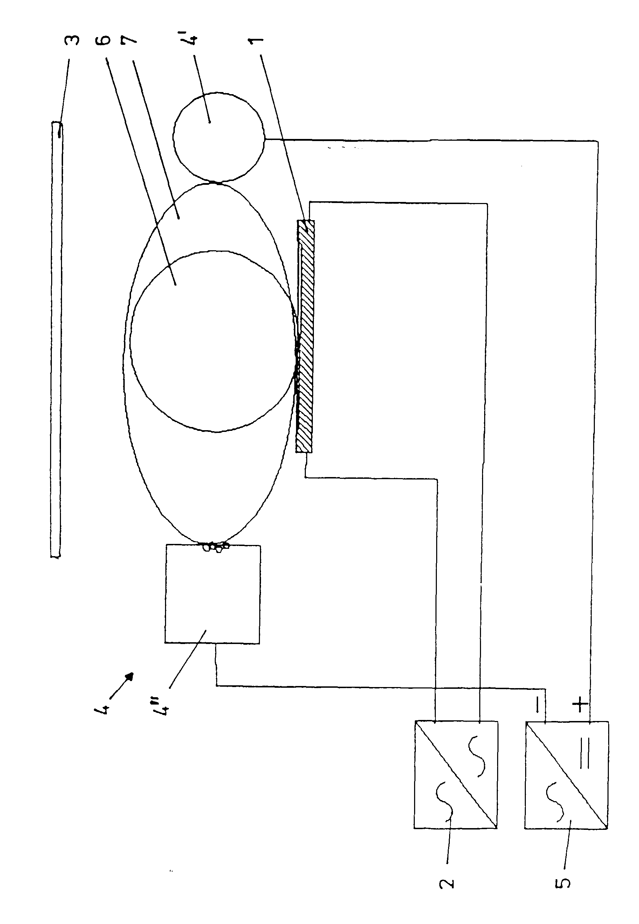

Ein Ausführungsbeispiel einer erfindungsgemäßen Vorrichtung zum Beschichten von Substraten mit einem Materialdampf im Unterdruck oder Vakuum wird anhand der Zeichnung beschrieben, die in rein schematischer Weise die erfindungsgemäße Beschichtungsvorrichtung zeigt, um das Grundprinzip zu erläutern.

Die Beschichtungsvorrichtung weist zunächst eine Materialdampfquelle 1 auf, bei der es sich im dargestellten Ausführungsbeispiel um einen thermischen Verdampfer handelt, der an ein entsprechendes Netzgerät 2 angeschlossen ist. Statt des thermischen Verdampfers ist es auch denkbar, den Materialdampf als Gas oder Gasgemisch aus Gaserzeugern oder Gasbehältern zuzuführen.

Gegenüberliegend zu der Materialdampfquelle 1 befindet sich das zu beschichtende Substrat 3, welches in der Zeichnung rein schematisch angedeutet ist.

Zwischen der Materialdampfquelle 1 und dem Substrat 3 befindet sich eine lonisationseinrichtung 4 mit kalter Anode 4' und kalter Kathode 4", die an ein entsprechendes Netzgerät 5 angeschlossen sind. Die Anode 4' weist eine geeignete Geometrie in Form einer sogenannten ausgedehnten Anode auf, so daß sich keine Stromkonzentrationen an der Anode bilden.

Die Beschichtungsvorrichtung funktioniert wie folgt:

Durch Aktivierung der Materialdampfquelle 1 mittels des Netzgerätes 2 wird ein schematisch angedeuteter Materialdampf 6 erzeugt. Nach dieser Aktivierung der Materialdampfquelle 1 wird über das Netzgerät 5 eine Spannung zwischen Anode 4' und Kathode 4" angelegt, die beispielsweise 60 V betragen kann. An der Oberfläche der Kathode 4" entstehen sogenannte Kathodenflecken, welche in der Zeichnung schematisch angedeutet sind und die eine Bogenentladung zwischen Anode 4' und Kathode 4" aufbauen. Auf dem Weg von der Kathode 4" zur Anode 4' ionisieren die emittierten Elektronen über unelastische Stöße den Materialdampf 6 unter Bildung eines Plasmas 7. Der Grad der lonisierung kann dabei über den Bogenstrom variiert werden. Durch die elektrische und räumliche Trennung von Materialdampfquelle 1 und lonisationseinrichtung 4 gibt es keinerlei gegenseitige störende Beeinflussung. Außerdem sind Aufdampfrate und lonisationsgrad voneinander entkoppelt und somit über einen großen Bereich unabhängig voneinander variier- und optimierbar. Durch die räumliche Trennung der Elektroden von der Materialdampfquelle 1 ergibt sich mit der Möglichkeit, den Ort der Ionisation in Bezug auf den Abstand zum Substrat 3 zu variieren, ein weiterer Parameter zur Optimierung.

In der Zeichnung nicht dargestellt ist die Möglichkeit der reaktiven Abscheidung, indem durch eine geeignete Reaktivgaszuführung ein entsprechendes Reaktivgas oder Reaktivgasgemisch in die lonisationszone geführt wird. Beispielsweise kann die Anode 4' in Rohrform ausgebildet sein und als Zuführung für ein Reaktivgas dienen. Durch definierte Öffnungen entlang des Rohres kann das Reaktivgas direkt in die Entladung des Lichtbogens geführt werden, wo es gezielt aktiviert werden kann. Wird beispielsweise in der Materialdampfquelle 1 Aluminium verdampft und über das Anodenrohr Sauerstoff zugeführt, so können Aluminiumoxidschichten bei hohen Abscheideraten auf dem Substrat 3 erzeugt werden.

In einem nicht dargestellten Ausführungsbeispiel können mehrere Quellen nebeneinander angeordnet sein, um so eine Bandbeschichtung in einer Bandbedampfungsanlage zu ermöglichen.

### Bezugszeichenliste

- 1: Materialdampfquelle
- 2: Netzgerät
- 3: Substrat
- 4: Ionisationseinrichtung
- 4': Anode
- 4": Kathode
- 5: Netzgerät
- 6: Materialdampf
- 7: Plasma

## Patentansprüche

1. Vorrichtung zum Beschichten von Substraten (3) mit einem Materialdampf (6) im Unterdruck oder Vakuum,
mit einer Materialdampfquelle (1)
sowie mit einer aus einer kalten Anode (4') und aus einer Kathode (4") bestehenden lonisationseinrichtung (4) zum lonisieren des Materialdampfes (6) in einer ein Plasma (7) erzeugenden, durch den Materialdampf (6) gestützten Bogenentladung zwischen Anode (4') und Kathode (4"),
wobei die Materialdampfquelle (1) und die lonisationseinrichtung (4) mit ihrer Anode (4') und Kathode (4") elektrisch voneinander getrennt sind,
**dadurch gekennzeichnet,**
daß die Kathode (4") eine kalte, selbstverzehrende Kathode (4") ist, bei der die Elektronenemission zum Aufbau der Bogenentladung in mikroskopisch kleinen, extrem heißen Kathodenflecken an der Oberfläche der Kathode (4") erfolgt.

2. Vorrichtung nach dem vorhergehenden Anspruch,
dadurch gekennzeichnet,
daß die Anode (4') und/oder die Kathode (4") zur Erreichung ihres gewünschten kalten Zustandes kühlbar oder heizbar ist (sind).

3. Vorrichtung nach einem der vorhergehenden Ansprüche,
dadurch gekennzeichnet,
daß die Anode (4') aus einem elektrisch leitenden, schwerschmelzenden sowie hochtemperaturfesten Material besteht.

4. Vorrichtung nach einem der vorhergehenden Ansprüche,
dadurch gekennzeichnet,
daß im Bereich der Anode (4') ein zusätzliches Magnetfeld angelegt ist.

5. Vorrichtung nach einem der vorhergehenden Ansprüche,
dadurch gekennzeichnet,
daß die Spannungsversorgung für Anode (4') und Kathode (4") gepulst ist.

6. Vorrichtung nach einem der vorhergehenden Ansprüche,
dadurch gekennzeichnet,
daß eine zusätzliche Einrichtung zur Erhöhung der Kathodenstabilität durch Homogenisierung des Kathodenabbrandes vorgesehen ist.

7. Vorrichtung nach einem der vorhergehenden Ansprüche,
dadurch gekennzeichnet,
daß eine zusätzliche Zündeinrichtung zur Zündung der Bogenentladung vorgesehen ist.

8. Vorrichtung nach einem der vorhergehenden Ansprüche,
dadurch gekennzeichnet,
daß eine zusätzliche Einrichtung zur Beschleunigung der Ionen vorgesehen ist.

9. Vorrichtung nach einem der vorhergehenden Ansprüche,
dadurch gekennzeichnet,
daß die lonisationseinrichtung (4) zwischen der Materialdampfquelle (1) und dem zu beschichtenden Substrat (3) angeordnet ist.

10. Vorrichtung nach einem der vorhergehenden Ansprüche,
dadurch gekennzeichnet,
daß der Abstand zwischen dem Ort der lonisationseinrichtung (4) und/oder dem Ort des zu beschichtenden Substrats (3) und/oder dem Ort der Materialdampfquelle (1) veränderbar ist.

11. Vorrichtung nach einem der vorhergehenden Ansprüche,
dadurch gekennzeichnet,
daß als Materialdampfquelle (1) ein Materialdampferzeuger mittels thermischem Verdampfen mit widerstands-, induktiv- oder elektronenstrahlbeheizten Tiegeln, mittels Sputtertechnik, anodischem oder kathodischem Lichtbogenverdampfen oder eine Materialdampfzuführung mit einem entsprechenden Gas oder Gasgemisch vorgesehen ist.

12. Vorrichtung nach einem der vorhergehenden Ansprüche,
dadurch gekennzeichnet,
daß der lonisationszone über eine entsprechende Zuführung ein Reaktivgas oder Reaktivgasgemisch zuführbar ist.

13. Vorrichtung nach Anspruch 12,
dadurch gekennzeichnet,
daß die Anode (4') als Zuführung für das Reaktivgas oder Reaktivgasgemisch ausgebildet ist.

14. Vorrichtung nach Anspruch 12 oder 13,
dadurch gekennzeichnet,
daß als Zuführung für das Reaktivgas oder Reaktivgasgemisch die Anode (4') in Rohrform mit Öffnungen ausgebildet ist.

## Claims

1. Device for coating substrates (3) with a material vapour (6) in a reduced pressure or vacuum,
with a material vapour source (1)
and an ionisation device (4) consisting of a cold anode (4') and a cathode (4") for ionising the material vapour (6) in an arc discharge supported by the material vapour (6) and generating a plasma (7) between the anode (4') and cathode (4"),
where the material vapour source (1) and the ionisation device (4) with its anode (4') and cathode (4") are electrically separated from each other,
characterised in that the cathode (4") is a cold consumable cathode (4") in which the electron emission to create the arc discharge takes place in microscopically small, extremely hot cathode spots on the surface of the cathode (4").

2. Device according to the previous claim,
characterised in that
the anode (4') and/or cathode (4") can be cooled or heated to achieve their required cold state.

3. Device according to any of the previous claims,
characterised in that
the anode (4') consists of an electrically conductive, low melting and high temperature resistant material.

4. Device according to any of the previous claims,
characterised in that
an additional magnetic field is applied in the area of the anode (4').

5. Device according to any of the previous claims,
characterised in that
the voltage supply for the anode (4') and cathode (4") is pulsed.

6. Device according to any of the previous claims,
characterised in that
an additional device is provided to increase the cathode stability by homogenising the cathode consumption.

7. Device according to any of the previous claims,
characterised in that
an additional ignition device is provided to ignite the arc discharge.

8. Device according to any of the previous claims,
characterised in that
an additional device is provided to accelerate the ions.

9. Device according to any of the previous claims,
characterised in that
the ionisation device (4) is arranged between the material vapour source (1) and the substrate (3) to be coated.

10. Device according to any of the previous claims,
characterised in that
the distance between the site of the ionisation device and/or the site of the substrate (3) to be coated and/or the site of the material vapour source (1) can be changed.

11. Device according to any of the previous claims,
characterised in that
the material vapour source (1) comprises a material vapour generator by means of thermal vaporisation with crucibles heated by resistance, induction or electron beam, by means of sputter technology, anodic or cathodic arc vaporisation or a material vapour supply with a corresponding gas or gas mixture.

12. Device according to any of the previous claims,
characterised in that
a reactive gas or reactive gas mixture can be supplied to the ionisation zone by way of a corresponding supply.

13. Device according to claim 12,
characterised in that
the anode (4') is formed as the supply for the reactive gas or reactive gas mixture.

14. Device according to claim 12 or 13,
characterised in that
as a supply for the reactive gas or reactive gas mixture, the anode (4') is formed tubular with openings.

## Revendications

1. Dispositif pour le recouvrement de substrats (3) au moyen d'un matériau en phase vapeur (6) sous pression réduite ou sous vide,
équipé d'une source de matériau en phase vapeur (1)
ainsi que d'un dispositif d'ionisation (4), se composant d'une anode froide (4') et d'une cathode (4"), permettant d'ioniser le matériau en phase vapeur (6) en une décharge en arc entre l'anode (4') et la cathode (4"), maintenue par le matériau en phase vapeur (6) et générant un plasma (7), la source du matériau en phase vapeur (1) et le dispositif d'ionisation (4) avec son anode (4') et sa cathode (4") étant séparés électriquement l'un de l'autre,
caractérisé en ce que la cathode (4") est une cathode (4") froide et autoconsommable, dans laquelle l'émission d'électrons permettant de constituer la décharge en arc est réalisée en taches cathodiques extrêmement chaudes et microscopiques à la surface de la cathode (4").

2. Dispositif selon la revendication précédente,
caractérisé en ce que l'anode (4') et/ou la cathode (4") peut (peuvent) être refroidie (s) ou chauffée(s) pour atteindre leur état froid souhaité.

3. Dispositif selon l'une des revendications précédentes,
caractérisé en ce que l'anode (4') se compose d'un matériau électriquement conducteur, difficilement fusible et résistant aux températures élevées.

4. Dispositif selon l'une des revendications précédentes,
caractérisé en ce qu'est appliqué un champ magnétique supplémentaire dans la zone de l'anode (4').

5. Dispositif selon l'une des revendications précédentes,
caractérisé en ce que l'alimentation en courant de l'anode (4') et de la cathode (4") est pulsée.

6. Dispositif selon l'une des revendications précédentes,
caractérisé en ce qu'il est prévu un dispositif supplémentaire permettant d'augmenter la stabilité cathodique par homogénéisation de la combustion cathodique.

7. Dispositif selon l'une des revendications précédentes,
caractérisé en ce qu'un dispositif d'allumage supplémentaire est prévu pour amorcer l'arc.

8. Dispositif selon l'une des revendications précédentes,
caractérisé en ce qu'un dispositif supplémentaire est prévu pour accélérer les ions.

9. Dispositif selon l'une des revendications précédentes,
caractérisé en ce que le dispositif d'ionisation (4) est disposé entre la source de matériau en phase vapeur (1) et le substrat à recouvrir (3).

10. Dispositif selon l'une des revendications précédentes,
caractérisé en ce que la distance entre l'emplacement du dispositif d'ionisation (4) et/ou l'emplacement du substrat à recouvrir (3) et/ou l'emplacement de la source du matériau en phase vapeur (1) peut être modifiée.

11. Dispositif selon l'une des revendications précédentes,
caractérisé en ce qu'il est prévu, en tant que source de matériau en phase vapeur (1), un générateur de matériau en phase vapeur par le biais d'une vaporisation thermique avec creuset chauffé par résistance, par induction ou par faisceau électronique, par le biais d'une technique de dépôt par pulvérisation, vaporisation par arc anodique ou cathodique, ou une alimentation en matériau en phase vapeur avec gaz ou mélange de gaz correspondant.

12. Dispositif selon l'une des revendications précédentes,
caractérisé en ce qu'un gaz réactif ou un mélange de gaz réactifs peut être amené dans la zone d'ionisation par le biais d'une alimentation correspondante.

13. Dispositif selon la revendication 12,
caractérisé en ce que l'anode (4') est conçue en tant qu'alimentation en gaz réactif ou mélange de gaz réactifs.

14. Dispositif selon la revendication 12 ou 13,
caractérisé en ce que, en tant qu'alimentation en gaz réactif ou mélange de gaz réactifs, l'anode (4') est conçue selon une forme de tube présentant des ouvertures.
